# EUROPEAN PATENT SPECIFICATION

(11) **EP 0 620 593 B1**
(45) Date of publication and mention of the grant of the patent: **02.12.1998**
(21) Application number: 94105135.1
(22) Date of filing: 31.03.1994
(51) Int. Cl.: H01L 23/495

(54) **Semiconductor device with power-supply bus leads**
Halbleiteranordnung mit Versorgungsbusleitungen
Dispositif semi-conducteur avec des conducteurs d'alimentation en forme de barre omnibus

(30) Priority: 16.04.1993 JP 90032/93; 22.03.1994 JP 50140/94
(43) Date of publication of application: 19.10.1994
(73) Proprietor: KABUSHIKI KAISHA TOSHIBA, Kawasaki-shi (JP)
(72) Inventor: Nakao, Mitsuhiro, c/o Int.Prop.Div., Tokyo 105 (JP); Ishikawa,Toshimitsu, c/o Int.Prop.Div., Tokyo 105 (JP); Hayashi, Kazunori, c/o Int.Prop.Div., Tokyo 105 (JP)
(74) Representative: Lehn, Werner, Dipl.-Ing.

(56) References cited:
- EP-A- 0 486 027
- PATENT ABSTRACTS OF JAPAN vol. 017, no. 344 (E-1390) 29 June 1993 & JP-A-05 047 819 (TEXAS INSTR JAPAN LTD) 26 February 1993
- PATENT ABSTRACTS OF JAPAN vol. 013, no. 074 (E-717) 20 February 1989 & JP-A-63 255 953 (SANKEN ELECTRIC CO LTD) 24 October 1988
- PATENT ABSTRACTS OF JAPAN vol. 014, no. 178 (E-0915) 10 April 1990 & JP-A-02 031 454 (HITACHI LTD) 1 February 1990
- PATENT ABSTRACTS OF JAPAN vol. 016, no. 031 (E-1159) 27 January 1992 & JP-A-03 244 149 (MITSUBISHI ELECTRIC CORP.) 30 October 1991
- PATENT ABSTRACTS OF JAPAN vol. 013, no. 404 (E-817) 7 September 1989 & JP-A-01 145 842 (NEC IC MICROCOMPUT SYST LTD) 7 June 1989
- PATENT ABSTRACTS OF JAPAN vol. 017, no. 556 (E-1444) 6 October 1993 & JP-A-05 160 333 (SHARP CORP) 25 June 1993

## Description

The present invention relates to a semiconductor device.

Various constructions for achieving electrical connection to semiconductor integrated circuits are described in JP-A-1 145 842 and JP-A-63 255 953.

A dynamic RAM may have its memory circuit divided into blocks to improve the processing speed.

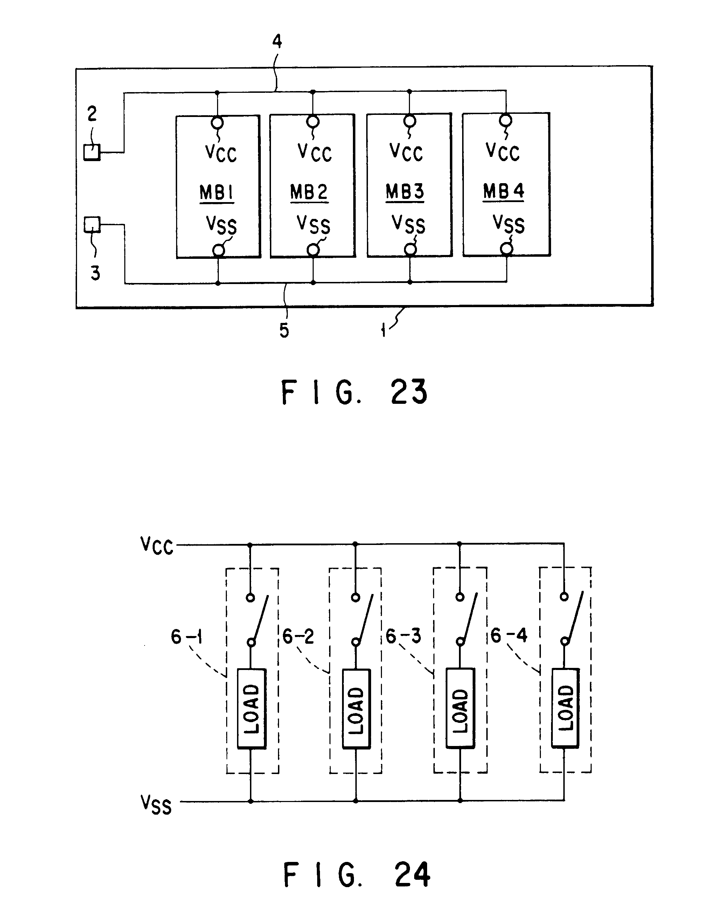

FIG. 23 is a structural diagram of a dynamic RAM chip with the memory circuit divided into blocks, and FIG. 24 is a diagram of the equivalent circuit of the RAM chip.

As shown in FIG. 23, a plurality of memory circuit blocks MB1 to MB4 are provided in a semiconductor chip 1. Power supplies are needed to operate the memory circuit blocks MB1 to MB4. Conventionally, one high-potential power supply pad 2 and one low-potential power supply pad 3 are provided at the boundary of the chip 1, with a high-potential power line 4 and a low-potential power line 5 respectively connected to the pads 2 and 3. Those power lines 4 and 5 are connected to the memory circuit blocks MB1 to MB4 to provide a low potential VSS and a high potential VCC required for their operation.

This structure, in the equivalent circuit shown in FIG. 24, has resistor elements 6-1 to 6-4 connected in parallel between the power lines 4 and 5, each resistor element having a series circuit of a switch and a load. The combined resistance in the parallel circuit in this memory circuit varies depending on the ON/OFF status of each switch or the ON/OFF status of each of the memory circuit blocks MB1-MB4, causing a variation in supply voltage.

It is apparent that the integration of the memory circuit blocks MB1-MB4 will be improved and the sensitivities of the elements constituting the memory circuit will be improved accordingly. Even a slight variation in supply voltage may therefore cause the memory circuit blocks MB1-MB4 to malfunction.

To overcome such a shortcoming, the present inventors attempted to divide the power supply for each memory circuit block.

In the attempt, a single memory circuit block in the equivalent circuit is simply connected in series between the power lines, thus overcoming the problem of the parallel connection to cause a variation in combined resistance. A variation in supply voltage could therefore be suppressed.

The provision of a power supply for each memory circuit block however increases the number of pads. The increasing number of pads inevitably increases the number of leads (number of pins), which requires that the package for a semiconductor chip should be enlarged. The larger package means the enlargement of the semiconductor device, interfering with the down-sizing of secondary products using this semiconductor device, such as computers and word processors. An unnecessary increase in the number of pins affects the easy handling of the semiconductor device.

It is an object of the present invention to provide a semiconductor device whose pins will not be increased unnecessarily and which can be housed in a small package.

According to the invention, there is provided a semiconductor device comprising:
a semiconductor chip having a plurality of sides and including at least first, second, third and fourth pads thereon, serving as outer electrodes;
a first lead member having a portion located at and extending substantially in parallel to one of said plurality of sides;
a second lead member having a portion located adjacent to said portion of said first lead member;
a first connection member electrically connecting said first lead member to said first pad;
a second connection member electrically connecting said second lead member to said second pad;
a third connection member electrically connecting said first lead member to said third pad; and
a fourth connection member electrically connecting said second lead member to said fourth pad, characterized in that said first and second lead members each have a plurality of alternating wider portions and narrower portions, the wider portions constituting projection portions, and recesses being defined between adjacent projection portions, said first and third connection members being electrically connected to at least one projection portion of said first lead member and said second and fourth connection members being electrically connected to at least one projection portion of said second lead member; and in that said first and second lead members are arranged adjacent to each other with said recesses and projection portions of said first lead member being interdigitated with said projection portions and recesses, respectively, of said second lead member.

With this structure, since the recess and projection of the first lead member are engaged with the projection and recess of the second lead member, those lead members can be placed adjacent to each other in a narrower area. This permits the package to be made smaller. As the projection is wide, it is possible to secure an area there to connect the connection members to the associated lead member.

This invention can be more fully understood from the following detailed description when taken in conjunction with the accompanying drawings, in which:
FIG. 1 is a plan view of a semiconductor device according to a first embodiment of the present invention;
FIG. 2 is a structural diagram of a dynamic RAM chip of the semiconductor device according to the first embodiment;
FIG. 3 is a perspective view of the semiconductor device according to the first embodiment;
FIG. 4 is a plan view of a semiconductor device according to a second embodiment of this invention;
FIG. 5 is a plan view of a semiconductor device according to a third embodiment of this invention;
FIG. 6 is a perspective view of the semiconductor device according to the third embodiment;
FIG. 7 is a plan view of a semiconductor device according to a fourth embodiment of this invention;
FIG. 8 is a perspective view of the semiconductor device according to the fourth embodiment;
FIG. 9A is a plan view of a semiconductor device according to a fifth embodiment of this invention;
FIG. 9B is a cross section taken along the line 9B-9B in FIG. 9A;
FIG. 10 is a cross section of the semiconductor device according to the fifth embodiment after packaged;
FIG. 11A is a plan view of a semiconductor device according to a sixth embodiment of this invention;
FIG. 11B is a cross section taken along the line 11B-11B in FIG. 11A;
FIG. 12A is a plan view of a semiconductor device according to a seventh embodiment of this invention;
FIG. 12B is a cross section taken along the line 12B-12B in FIG. 12A;
FIGS. 13A through 13C are cross-sectional views during fabrication of the semiconductor device according to the seventh embodiment;
FIG. 14A is a plan view of a semiconductor device according to an eighth embodiment of this invention;
FIG. 14B is a cross section taken along the line 14B-14B in FIG. 14A;
FIG. 15A is a cross-sectional view during fabrication of the semiconductor device according to the eighth embodiment;
FIG. 15B is a cross section taken along the line 15B-15B in FIG. 15A;
FIG. 16 is a plan view during fabrication of the semiconductor device according to the eighth embodiment;
FIG. 17A is a plan view of a semiconductor device according to a ninth embodiment of this invention;
FIG. 17B is a cross section taken along the line 17B-17B in FIG. 17A;
FIG. 18A is a plan view of a semiconductor device according to a tenth embodiment of this invention;
FIG. 18B is a cross section taken along the line 18B-18B in FIG. 18A;
FIG. 19 is a plan view of a semiconductor device according to an eleventh embodiment of this invention;
FIG. 20 is a plan view of a semiconductor device according to a twelfth embodiment of this invention;
FIG. 21 is a plan view of a semiconductor device according to a thirteenth embodiment of this invention;
FIG. 22 is a plan view of a semiconductor chip according to a fourteenth embodiment of this invention;
FIG. 23 is a structural diagram of a typical dynamic RAM chip; and
FIG. 24 shows an equivalent circuit of the typical dynamic RAM chip.

Preferred embodiments of the present invention will now be described referring to the accompanying drawings. Same reference numerals will be given to corresponding or identical portions of different embodiments throughout the following description to avoid their redundant description.

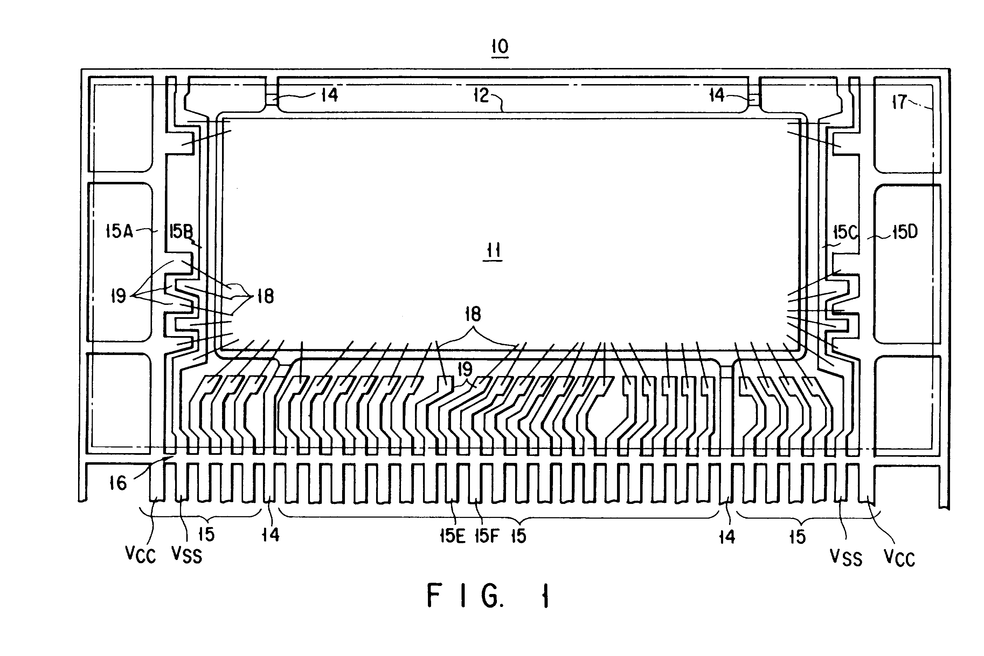

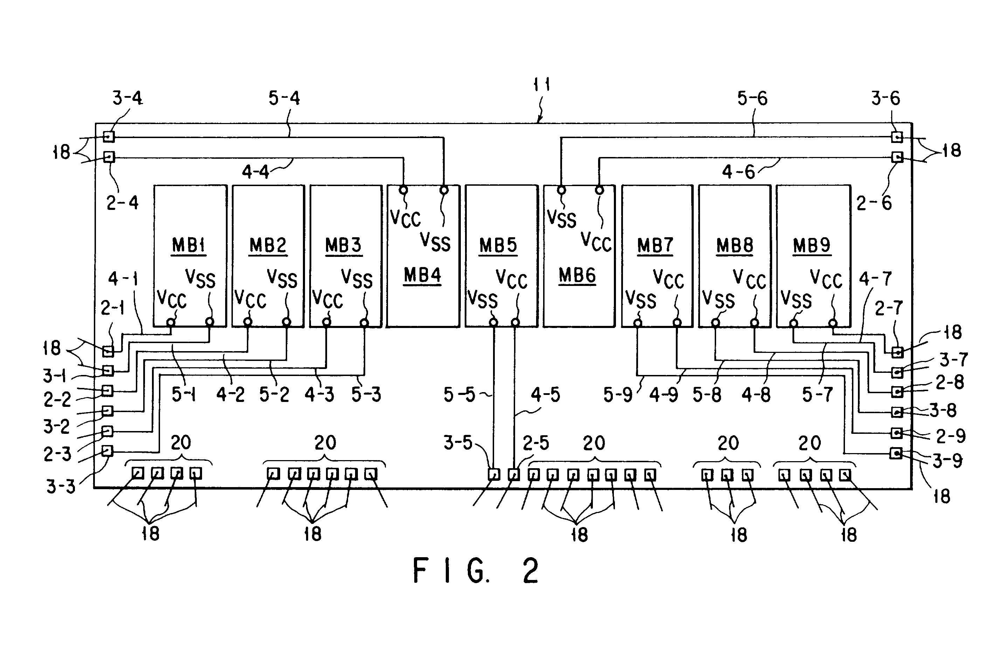

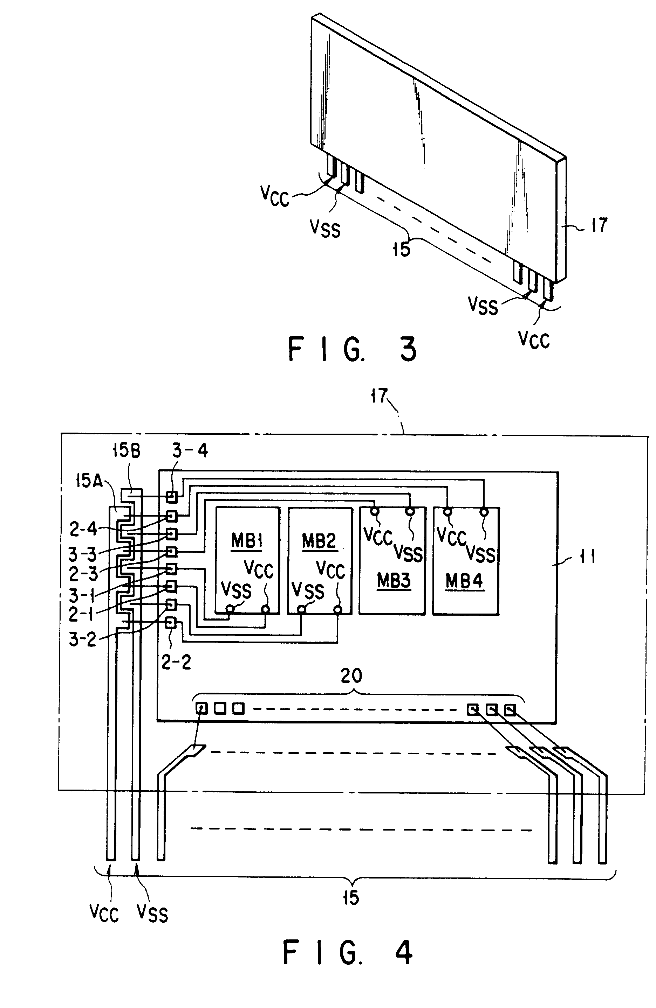

FIG. 1 is a plan view of a semiconductor device according to a first embodiment of the present invention, FIG. 2 is a block diagram showing the schematic structure of a dynamic RAM chip shown in FIG. 1, and FIG. 3 is a perspective view of the semiconductor device after packaged. FIG. 1 shows a chip mounted on a lead frame.

As shown in FIG. 1, a metal lead frame 10 mainly comprises a bed 12 on which a chip 11 is mounted, tie bars 14 for linking the bed 12 to the frame 10, leads 15 which later serve as pins, and a dam bar 16 for preventing resin from leaking out from the clearance between the leads 15 at the time the resin is sealed. Reference numeral "17" denotes a mold resin that is formed later to seal the chip. After the chip 11 is sealed with the mold resin 17, the dam bar 16 is cut and outer leads are cut and formed, yielding a SIP (Single In-line Package) type semiconductor device as shown in FIG. 3. This semiconductor device will be supplied to the market.

That portion of the lead 15 which is fitted in the mold resin 17 is generally called an "inner lead" while the portion which comes out of the mold resin 17 is called an "outer lead." The outer leads extending outside the mold resin 17 later serve as external pins (see FIG. 3).

Each inner lead portion is provided with a bonding area 19 where a bonding wire 18 is to be bonded. The width of the inner lead at the bonding area 19 is wider than the other portion to ensure wire bonding.

Of the leads 15, leads 15A, 15B and 15C and 15D located at the edges, unlike the other leads, extend parallel to the sides of the chip 11. A high potential VCC is applied to the outermost leads 15A and 15D closest to the edges. A low potential VSS (e.g., ground potential) is applied to the lead 15B adjacent to the lead 15A, and a low potential VSS (e.g., ground potential) is applied to the lead 15C adjacent to the lead 15D. Accordingly, after the chip 11 shown in FIG. 1 is sealed with resin, the high potential VCC is applied to the outermost pins while the low potential VSS is applied to the pins adjacent to the outermost pins, as shown in FIG. 3.

Each of the leads 15A-15D is notched, so that each of the leads 15A-15D has a plurality of recesses and a plurality of projections formed alternately and continuously. The projection portions of each of the leads 15A-15D are wider than the other portions thereof, and the bonding areas 19 are provided on the projections. The projections and recesses of the lead 15B are interdigitated with the recesses and projections of the adjoining lead 15A. Likewise, the projections and recesses of the lead 15C are interdigitated with the recesses and projections of the adjoining lead 15D.

One ends of the bonding wires 18 are connected to the respective projections and the respective bonding areas 19 located at the distal ends of the inner leads, and the other ends connected to pads 2-1 to 2-9, 3-1 to 3-9 and 20 provided along the along the edges of the chip 11 (see FIG. 2).

As shown in FIG. 2, a plurality of dynamic memory circuit blocks MB1 to MB9 are provided in the chip 11. Power supplies for operating the memory circuit blocks MB1-MB9 are provided separately block by block.

In the described semiconductor device, to provide a power supply for each memory circuit block, high-potential (VCC) power supply pads 2-1 to 2-9 and low-potential (VSS) power supply pads 3-1 to 3-9 are provided in association with the memory circuit blocks MB1-MB9.

The high-potential power supply pads 2-1 to 2-9 are connected to the respective memory circuit blocks MB1-MB9 via high-potential power lines 4-1 to 4-9. The low-potential power supply pads 3-1 to 3-9 are connected to the respective memory circuit blocks MB1-MB9 via low-potential power lines 5-1 to 5-9.

The high-potential power supply pads 2-1 to 2-4 are electrically connected to the lead 15A via the bonding wires 18, and the high-potential power supply pads 2-6 to 2-9 are electrically connected to the lead 15D via the bonding wires 18. The high-potential power supply pad 2-5 is electrically connected to another lead 15F (see FIG. 1) via the bonding wire 18.

The low-potential power supply pads 3-1 to 3-4 are electrically connected to the lead 15B via the bonding wires 18, and the low-potential power supply pads 3-6 to 3-9 are electrically connected to the lead 15C via the bonding wires 18. The low-potential power supply pad 3-5 is electrically connected to another lead 15E (see FIG. 1) via the bonding wire 18.

It is desirable that power supply to the memory circuit blocks MB1-MB9 be accomplished using the leads 15A, 15B, 15C and 15D as much as possible to suppress an increase in the number of pins. If there is some restrictions like the circuit layout in the chip 11 being difficult, the power supply to the memory circuit blocks MB1-MB9 may be accomplished using the leads 15E and 15F as per the first embodiment. In this case too, the leads 15A and 15B are shared by the memory circuit blocks MB1-MB4 and the leads 15C and 15D are shared by the memory circuit blocks MB6-MB9, so that an unnecessary increase in the number of pins can be avoided.

A plurality of pads denoted by reference numeral "20" in FIG. 2 include signal input/output pads and high-potential/low-potential power supply pads for providing supply voltages necessary to operate the peripheral circuits (not shown). The details of the input signals, output signals and the peripheral circuits will not be given in this specification.

A second embodiment of this invention will now be described.

FIG. 4 is a plan view schematically showing a semiconductor device according to the second embodiment.

In the semiconductor device described above referring to FIGS. 1 through 3, the leads 15A and 15B each have a series of recesses and projections extending along one side of the chip 11, and the leads 15C and 15D each have a series of recesses and projections extending along the opposite side of the chip 11.

The leads 15C and 15D may be eliminated and the leads 15A and 15B each having recesses and projections may be formed to extend along only one side of the chip 11, as shown in FIG 4.

The second embodiment with the above structure will have the same advantages as the first embodiment.

A third embodiment of this invention will be described below.

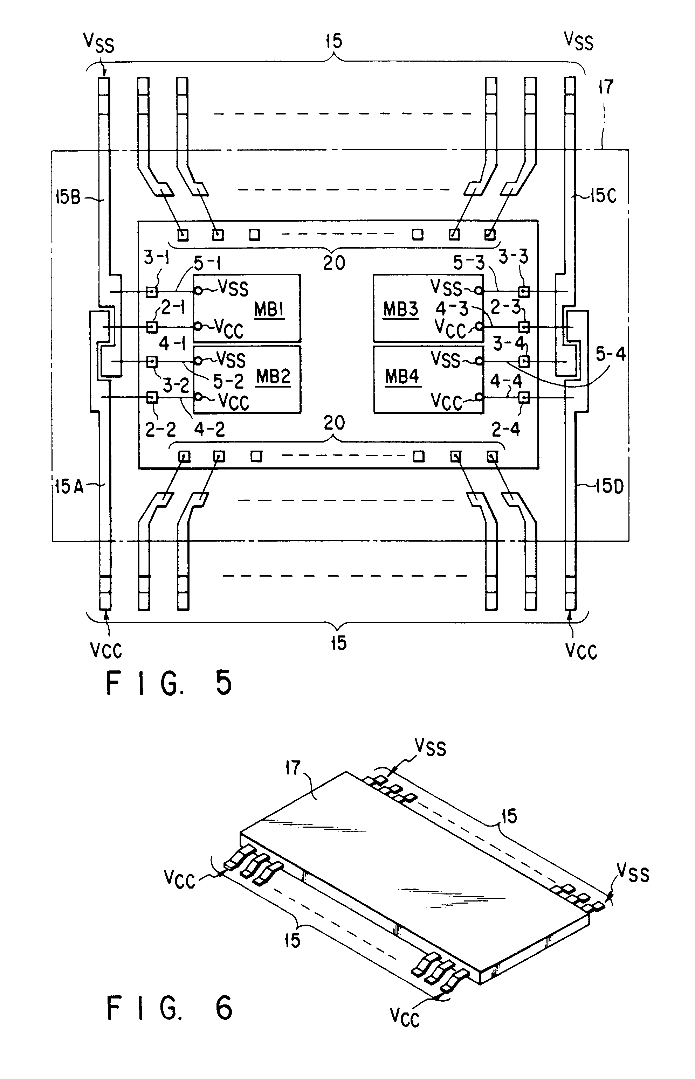

FIG. 5 is a plan view of a semiconductor device according to the third embodiment of the present invention, and FIG. 6 is a perspective view of the semiconductor device after packaged.

The semiconductor devices of the first and second embodiments described with reference to FIGS. 1 through 4 are both SIP semiconductor devices.

Those semiconductor devices may be modified to be an SOP (Small Out-line Package) type or DIP (Dual In-line Package) type in which external pins are led out from opposite sides of the mold resin 17.

In this embodiment, the lead 15A which is applied with the high potential VCC and the lead 15B which is applied with the low potential VSS are led out in the opposite directions. Similarly, the leads 15D and 15C are led out in the opposite directions.

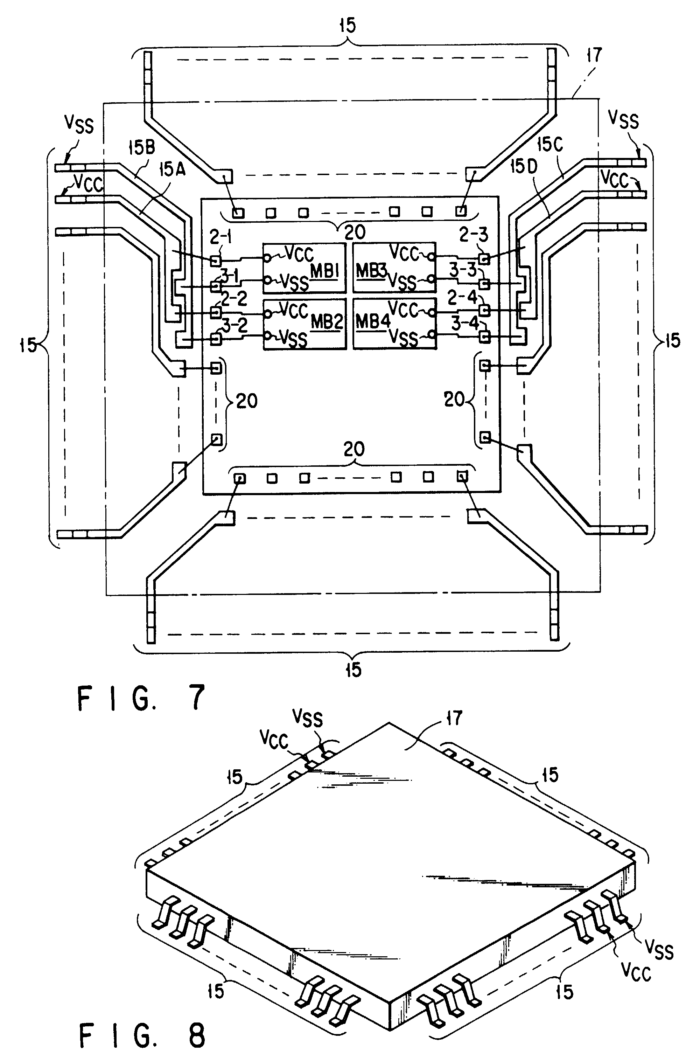

FIG. 7 is a plan view of a semiconductor device according to a fourth embodiment of the present invention, and FIG. 8 is a perspective view of this semiconductor device after packaged.

The semiconductor device may be modified to be a QFP (Quad Flat Package) type having pins provided in four directions, as well as an SIP type and DIP type.

A fifth embodiment of this invention will be described below.

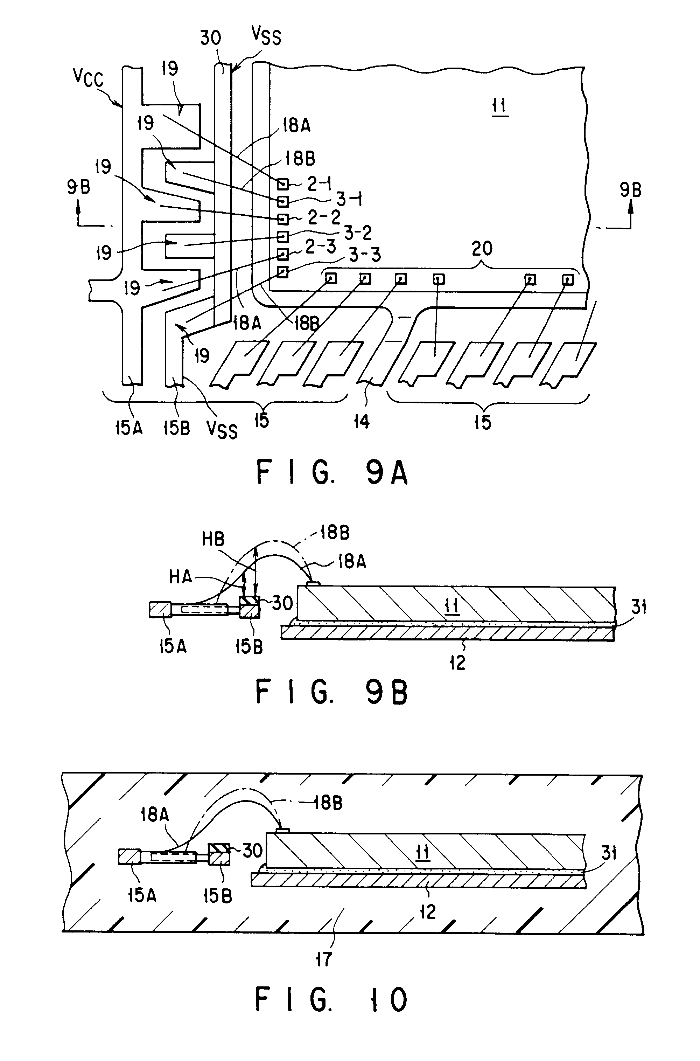

FIGS. 9A and 9B show a semiconductor device according to the fifth embodiment of this invention, FIG. 9A being a plan view showing the main portions in enlargement and FIG. 9B being a cross section taken along the line 9B-9B in FIG. 9A.

As shown in FIGS. 9A and 9B, the lead 15B is located between the lead 15A and the chip 11. First ends of the bonding wires 18A are connected to the high-potential power supply pads 2-1 to 2-3, and the second ends are connected to the bonding areas 19 provided on the projections of the lead 15A. The bonding wires 18A extend over the lead 15B. First ends of the bonding wires 18B are connected to the low-potential power supply pads 3-1 to 3-3, and the other ends are connected to the bonding areas 19 provided on the projections of the lead 15B. An insulating layer 30 is formed on the lead 15B. The insulating layer 30 is provided in association with the area over which the bonding wires 18A extend. In this embodiment, the insulating layer 30 is provided in the portion of the lead 15B which faces the chip 11 and excludes the projections.

In FIG. 9B, an adhesive layer 31 serves to adhere the chip 11 on the bed 12.

In this device, the bonding length of the wire 18A is longer than that of the wire 18B. In the wire bonding, as the wire bonding length increases, the loop heights HA and HB become gradually lower. The lower the loop heights HA and HB become, the greater the chance that the wires would move with the mold resin at the time of molding so that the wires may contact the leads. This possibility would increase particularly for devices which are designed to have narrower pitches between leads or narrower pitches between pads to increase the number of pins while suppressing an increase in package size. If the device is of this type, the loop height HA of the wire 18A is lower than the loop height HB of the wire 18B, thus increasing the chance of the wire 18A contacting the lead 15B.

In a device having the insulating layer 30 on the lead 15B as shown in FIGS. 9A and 9B, even if the wire 18A is moved to contact the lead 15B by the mold resin, the existence of the insulating layer 30 on the lead 15B prevents the wire 18A and the lead 15B from being short-circuited.

The insulating layer 30 shown in FIGS. 9A and 9B is formed by coating an insulating material on the lead 15B before wire bonding or adhering an insulating tape thereon. After packaging, therefore, the insulating layer 30 made of an insulating material other than the mold resin 17 is located on the lead 15B as shown in FIG. 10.

A sixth embodiment of this invention will be described below.

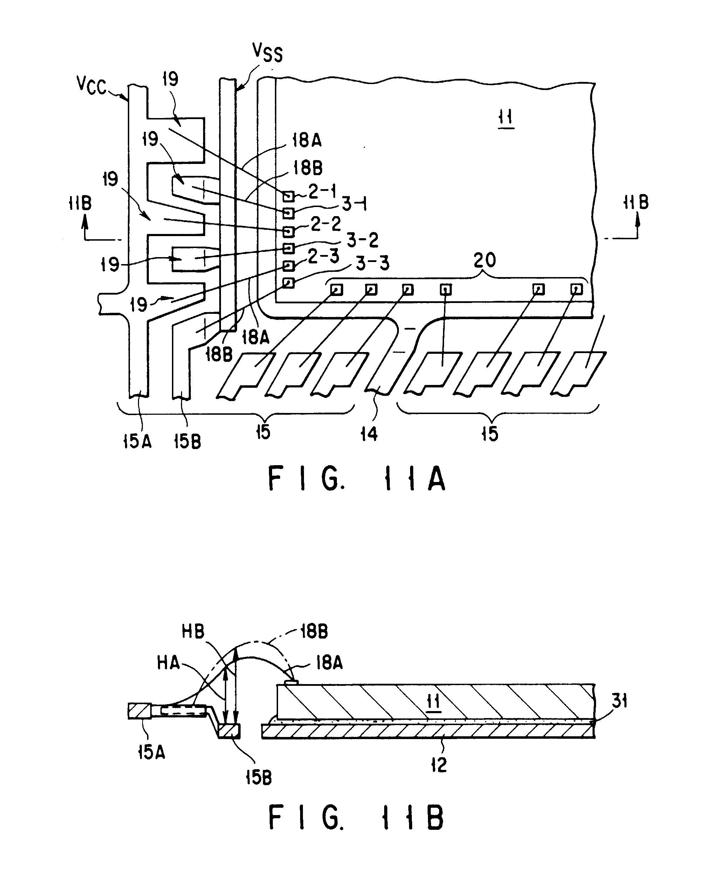

FIGS. 11A and 11B show a semiconductor device according to the sixth embodiment of this invention, FIG. 11A being a plan view showing the main portions in enlargement and FIG. 11B being a cross section taken along the line 11B-11B in FIG. 11A.

As shown in FIGS. 11A and 11B, the lead 15B located between the outermost lead 15A and the chip 11, excluding the projections is pushed downward away from the bonding wires 18A and 18B. Consequently, the lead 15B excluding the projections is positioned lower than the surface of the bonding area 19 provided on that projection.

In the semiconductor device with the above structure, as the lead 15B excluding the projections is placed away from the wires 18A and 18B, the loop height HA of the wire 18A can be increased. The chance of the wire 18A contacting the lead 15B can be reduced as per the fifth embodiment. It is therefore possible to prevent the short-circuiting from occurring by the contact of the wire 18A with the lead 15B.

The lead 15B having a shape as shown in FIGS. 11A and 11B may be formed by depressing the lead 15B at the same time as the bed 12 in the depressing step for the bed 12 which is carried out to make the package as thin as possible.

A seventh embodiment of this invention will be described below.

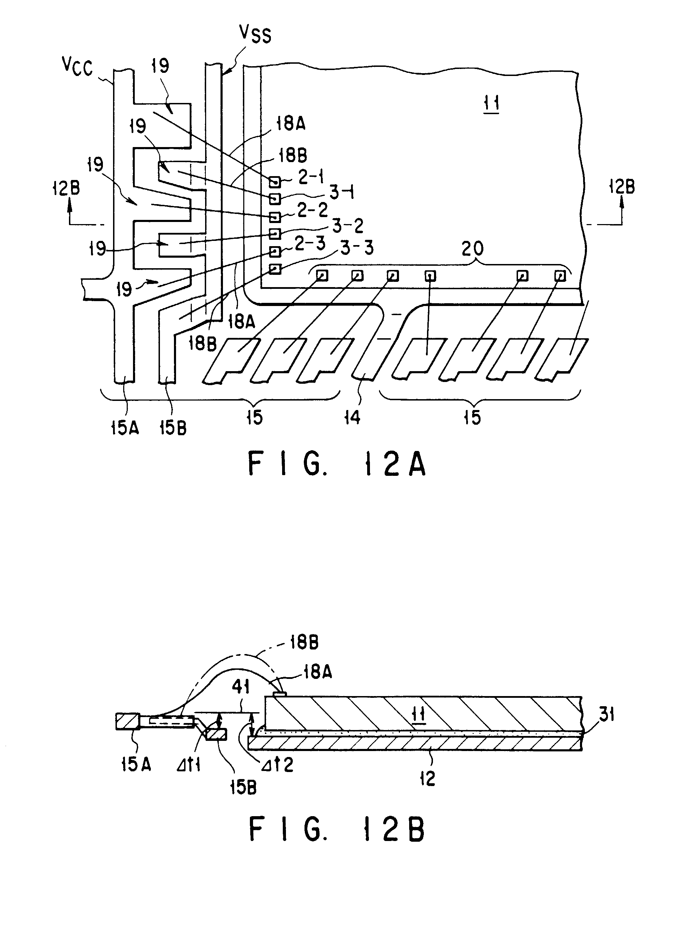

FIGS. 12A and 12B show a semiconductor device according to the seventh embodiment of this invention, FIG. 12A being a plan view showing the main portions in enlargement and FIG. 12B being a cross section taken along the line 12B-12B in FIG. 12A.

As shown in FIGS. 12A and 12B, the device according to the seventh embodiment is similar to the one shown in FIGS. 11A and 11B. The difference lies in that the surface position of the lead 15B excluding the projections comes between the surface position of the lead 15A and the surface position of the bed 12. FIG. 12B shows a straight line 41 representing the surface position of the lead 15A. The distance from the line 41 to the surface position of the lead 15B excluding the projections is Δt1, and the distance from the line 41 to the surface position of the bed 12 is Δt2. The distance Δt1 is shorter than Δt2.

The device with the above structure can prevent the lead 15B from being badly deformed or broken, and can prevent short-circuiting between the lead 15B and the wires 18A and 18B.

The lead 15B is not supported on the frame in the direction along the line 12B-12B in FIG. 12A. FIG. 1 which has already been discussed shows the details. Suppose the lead 15B is depressed at the same time as the bed 12 using such a lead frame. If the depressed amount of the bed 12 is larger than that of the lead 15B, the lead 15B does not have a support along the line 12B-12B at the pressing time and is pulled toward the bed 12. This tension deforms the lead 15 badly, causing necking or breaking the lead 15B at the worst.

A method of fabricating a semiconductor device according to the seventh embodiment will now be described.

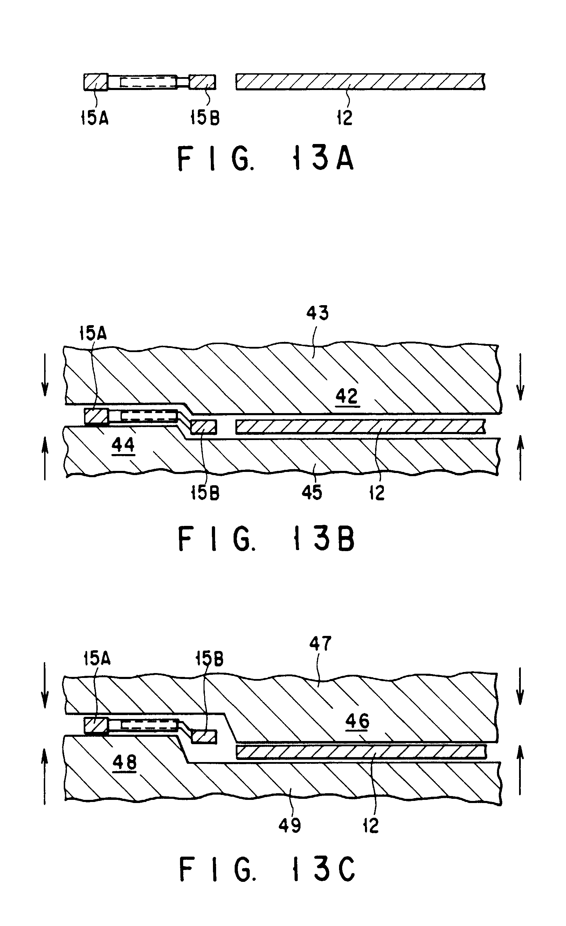

FIGS. 13A to 13C are cross sections during fabrication of the semiconductor device according to the seventh embodiment.

FIG. 13A shows a lead frame before depression.

The lead frame as shown in FIG. 13A is pressed with an upper mold 43 having a punch 42 for pressing the bed 12 and the lead 15B excluding the projections and a bottom mold 45 having a punch 44 for lifting only the lead 15A including the projections and the projections of the lead 15B, as shown in FIG. 13B.

Next, with the pressing mold changed, the lead frame is pressed again with an upper mold 47 having a punch 46 for further pressing only the bed 12 and a bottom mold 49 having a punch 48 for lifting only the lead 15A including the projections and the projections of the lead 15B.

As the pressing of the lead frame is separated to two steps: a first step with a small pressing amount followed by a second step with a larger pressing amount for depressing only the bed 12. It is possible to prevent the lead 15B from being badly deformed or broken.

An eight embodiment of this invention will be described below.

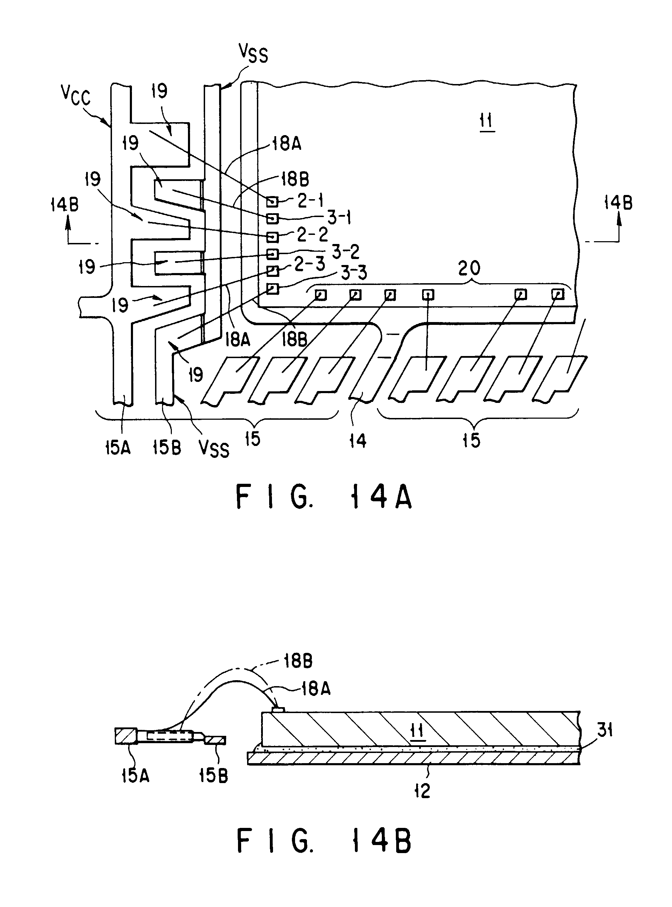

FIGS. 14A and 14B show a semiconductor device according to the eighthembodiment of this invention, FIG. 14A being a plan view showing the essential portions in enlargement and FIG. 14B being a cross section taken along the line 14B-14B in FIG. 14A.

As shown in FIGS. 14A and 14B, the device according to the eighth embodiment is designed for the same purpose as that of the devices according to the fifth to seventh embodiments, i.e., to prevent short-circuiting between the lead 15B and the wires 18A and 18B.

As shown in FIGS. 14A and 14B, the surface of the lead 15B excluding the projections is etched out away from the wires 18A and 18B.

As the portion of the lead 15B excluding the projections is set apart from the wires 18A and 18B, the device with this structure, like the fourth embodiment, can prevent the short-circuiting of the wire 18A and the lead 15B.

A method of fabricating a semiconductor device according to the eighth embodiment will now be described.

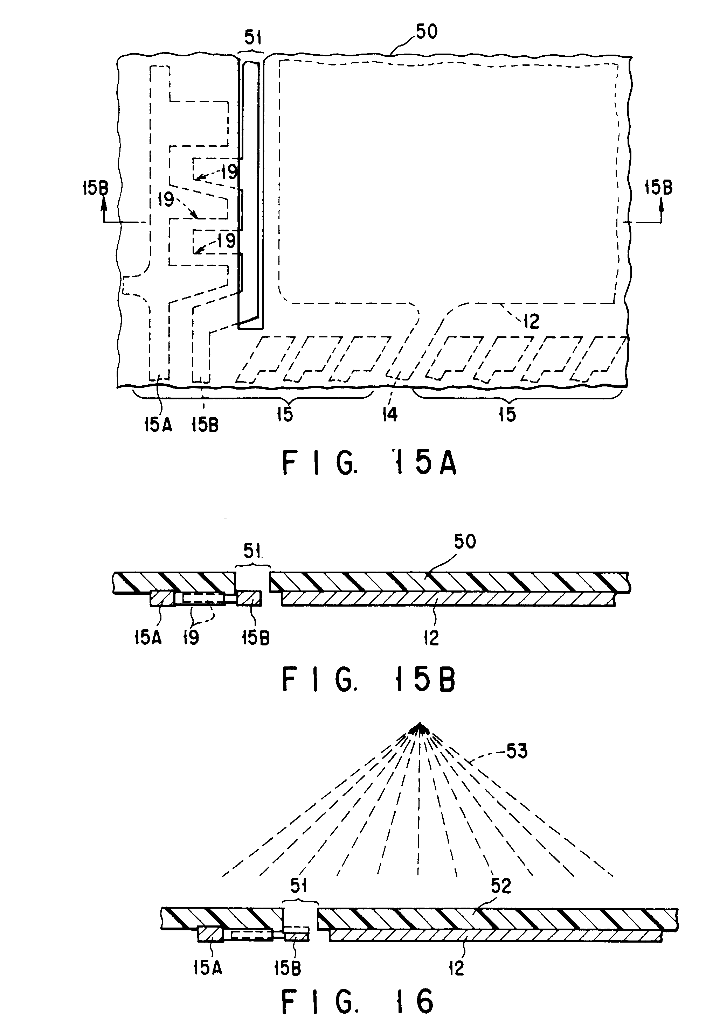

FIG. 15A is a plan view during fabrication of the semiconductor device according to the eighth embodiment, and FIG. 15B is a cross section taken along the line 15B-15B in FIG. 15. FIG. 16 is a cross section during fabrication of the semiconductor device according to the eighth embodiment.

First, masking tape having an opening 51 corresponding to the portion of the lead 15B excluding the projections is stuck on the top surface of the lead frame. Then, an etching liquid 53 is sprayed as shown in FIG. 16. The etching liquid 53 reaches the surface of the lead 15B via the opening 51, etching only the top surface of the lead 15B excluding the projections. This method forms the lead frame as shown in FIGS. 14A and 14B.

A ninth embodiment of this invention will be described below.

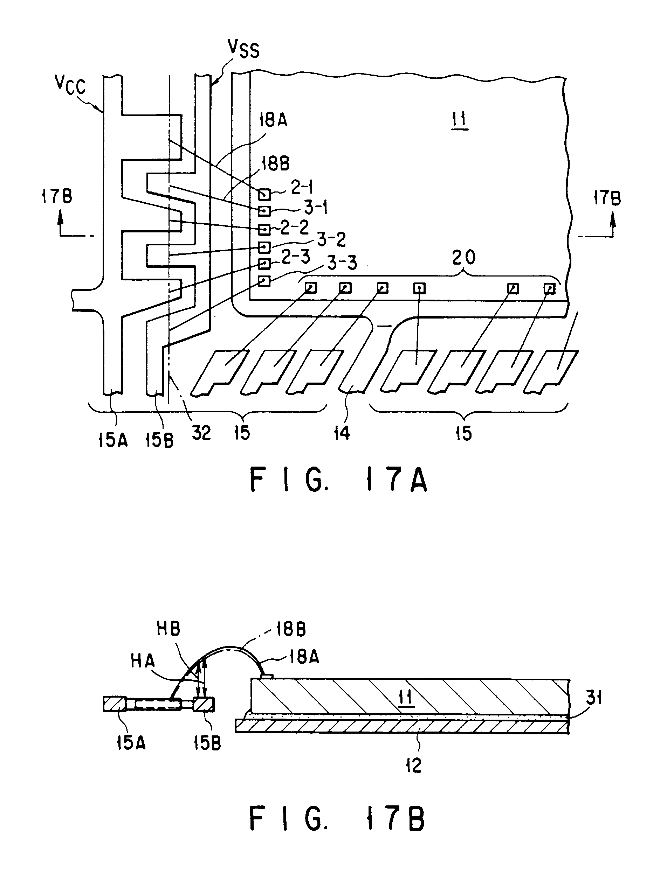

FIGS. 17A and 17B show a semiconductor device according to the ninth embodiment of this invention, FIG. 17A being a plan view showing the main portions in enlargement and FIG. 17B being a cross section taken along the line 17B-17B in FIG. 17A.

In the semiconductor devices according to the first to eighth embodiments, the leads 15A and 15B each have a series of recesses and projections, and the leads 15A and 15B are arranged adjacent to each other with the recesses and projections of the lead 15 A being interdigitated with the projections and recesses of the lead 15B.

In the semiconductor devices having such a structure, the connecting positions between the bonding areas 19 and the wires 18A and 18B can be set on one imaginary line 32 as shown in FIGS. 17A and 17B.

When the connecting positions are set on the single imaginary line 32, the wires will have nearly uniform bonding lengths. The uniform bonding length reduces any variation in loop heights HA and HB of the wires, thus reducing the chance of causing the wire 18A connected to the lead 15A to contact the lead 15B. Like the fourth to eighth embodiments, the ninth embodiment can prevent the short-circuiting of the wire 18A and the lead 15B.

The connection of the wires 18A and 18B shown in FIGS. 17A and 17B can be accomplished in all the semiconductor devices of the first to eighth embodiments.

A tenth embodiment of this invention will be described below.

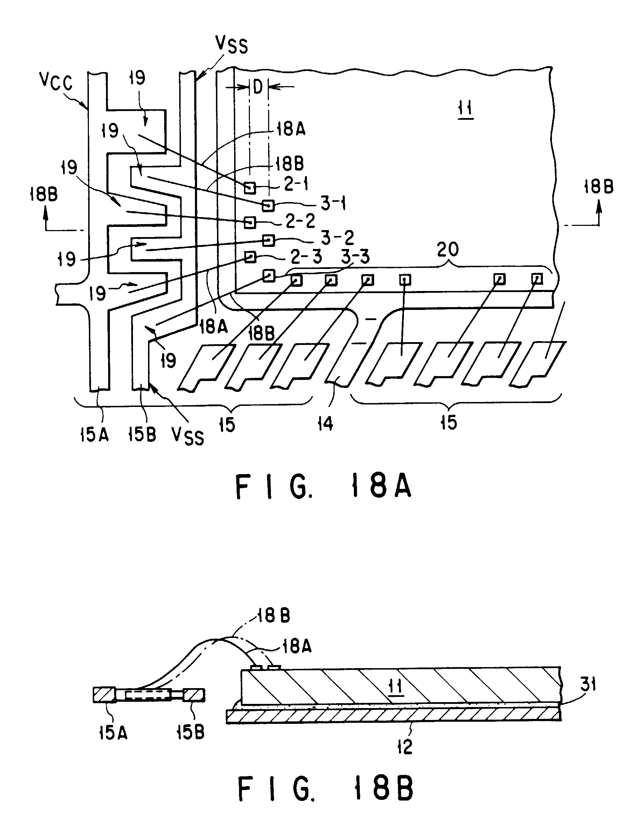

FIGS. 18A and 18B show a semiconductor device according to the tenth embodiment of this invention, FIG. 18A being a plan view showing the essential portions in enlargement and FIG. 18B being a cross section taken along the line 18B-18B in FIG. 18A.

The first lead 15A and the second lead 15B of the device each have a series of recesses and projections. Unless the system explained in the section of the ninth embodiment (see FIGS. 17A and 17B) is employed positively, the bonding positions of the wire 18A would be shifted from the bonding position of the wire 18B, so that the length of the wire 18A would differ from that of the wire 18B.

In the device according to the tenth embodiment, the wires 18A and 18B will have nearly the same length using a different system from that of the ninth embodiment.

The positions where the high-potential pads 2-1 to 2-3 on the chip 11 are shifted from the positions where the low-potential pads 3-1 to 3-3 are formed as shown in FIGS. 18A and 18B. The former pads are separated from the latter pads by a distance D in FIG. 18A.

The wires 18A and 18B will have nearly the same length by shifting the bonding positions on the chip side, i.e., shifting the positions of the high-potential pads from the positions of the low-potential pads.

A eleventh embodiment of this invention will be described below.

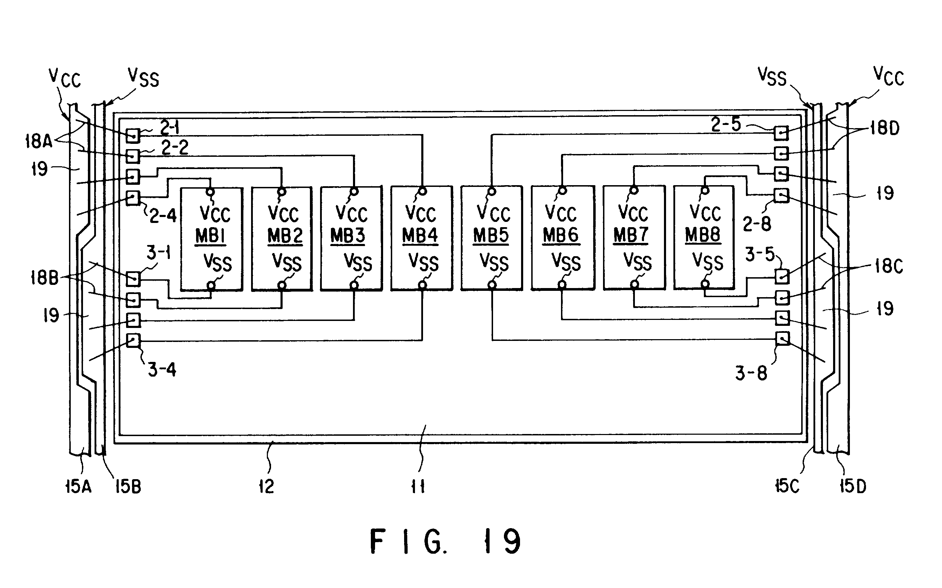

FIG. 19 is a plan view of a semiconductor device, according to the eleventh embodiment.

As shown in FIG. 19, a plurality of wires 18A may be connected to one projection of the lead 15A and a plurality of wires 18B may be connected to one projection of the lead 15B. In this case, the high-potential power supply pads 2-1 to 2-4 and the low-potential power supply pads 3-1 to 3-4 are provided collectively, not alternately, in the chip 11.

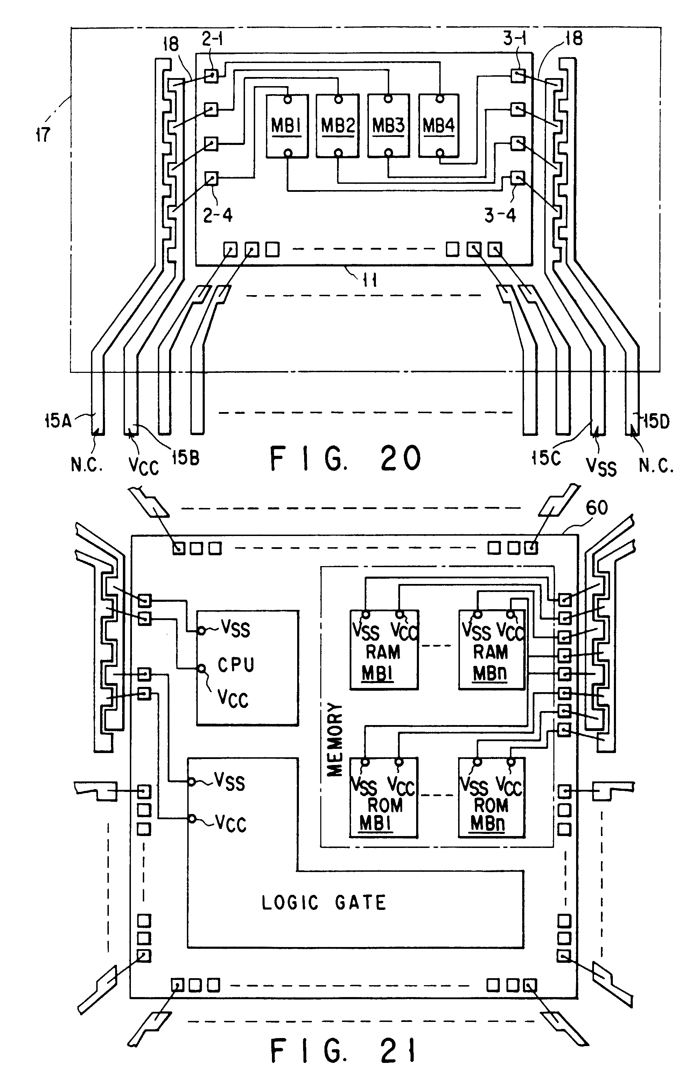

FIG. 20 is a plan view of a semiconductor device according to a twelfth embodiment of this invention.

The device of the twelfth embodiment relates to an example of using a lead frame.

When a semiconductor device has adjoining leads 15A and 15B and adjoining leads 15C and 15D as shown in FIG. 20, the wires 18 may not be connected properly.

For example, this may occur when only the high-potential power supply pads 2-1 to 2-4 are arranged at one edge of the chip 11 and only the low-potential power supply pads 3-1 to 3-4 are located at the opposite edge.

In this case, the leads which are not used, the leads 15A ad 15D in this example, should be left unconnected (N.C.).

FIG. 21 is a plan view of a semiconductor device according to a thirteenth embodiment of this invention.

This device relates to another example of a mountable IC chip.

The chip to be mounted may be a microcomputer chip 60 with a CPU, a logic unit and memory integrated as shown in FIG. 21. In the microcomputer 60, power supplies are respectively connected to the circuit blocks.

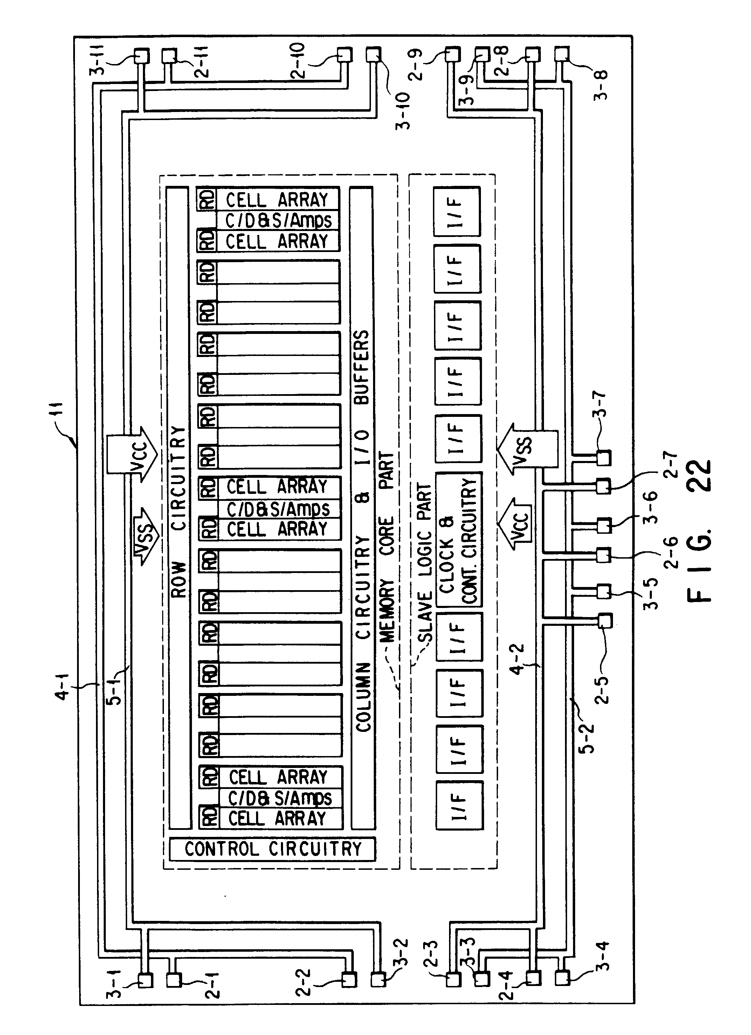

FIG. 22 is a plan view of a semiconductor device according to the fourteenth embodiment of the present invention, which relates to an IC chip 11.

The IC chip 11 is a RAmbus dynamic RAM (hereinafter refereed to as "RDRAM"). As shown in FIG. 22, the RDRAM chip 11 comprises to major circuit parts. The first major circuit part is a memory core part which has the same structure as an ordinary DRAM. The second major circuit part is a slave (interface) logic part which functions as an interface connected to the memory core part. The the RDRAM chip 11 differs from an ordinary DRAM in that it has a slave logic part.

The memory core part, i.e., the first major circuit part, includes a plurality of memory blocks (9 blocks shown in FIG. 22). Each memory block comprises two memory cell arrays (18 arrays shown in FIG. 22), two row decoder (RD), each provided for one memory cell array, two sense amplifiers (S/Amp), each used for one memory cell array, and one column decoder (C/C) provided for two memory cell arrays. The memory core part further includes a memory peripheral circuitry which comprises a row circuitry, a column circuitry, and a control circuitry. The row circuitry has row address signal buffers. The column circuitry has column address signal buffers. The control circuitry has an input and output (I/O) buffers, a counter circuit, a data refresh circuit and the like.

The slave logic part, i.e., the second major circuit part, includes interface (I/F) circuits, each provided for one memory block, clock circuits, and a control (CONT.) circuit for controlling the operating timing of the interface circuits.

The RDRAM chip 11 incorporates power supplies of the type shown in FIG. 2, each provided for each memory block included in the memory core part, and an independent power supply provided for the slave logic part. The RDRAM chip 11 has a lead frame of the type shown in the FIG. 1. Having these power supplies and the lead frame, the RDRAM scarcely makes errors, has a small number of pins, and can be manufactured in the form of a small package.

FIG. 22 also illustrates another type of a power supply system. More specifically, the memory core part has one VCC power supply rail 4-1 and one VSS power supply rail 5-1, rather than having a power supply for one memory block. A plurality of pads are connected to the power supply rail 4-1, and a plurality of pad are connected to the power supply 5-1. The power supply rail 4-1 is therefore electrically connected, at any parts, to the VCC leads and VSS leads. Similarly, the power supply rail 4-1 is therefore electrically connected, at any parts, to the VCC leads and VSS leads. Potential fluctuation can thereby be prevented in both power supply rails 4-1 and 5-1, as in a chips wherein a power supply is provided for one memory block.

In the RDRAM of FIG. 22, pads 2-5 to 2-7 are connected to a power supply rail 4-2, and pads 3-5 to 3-7 are connected to a power supply rail 5-2 -- all concentratedin the vicinity of a clock and control circuitry. The clock and control circuitry controls high-speed data transfer performed at a rate of, for example, 500 mega bytes per second, and many make errors even if the power-supply potential changes only a little. Although the clock and control circuitry is very sensitive electrically, it scarcely make error since the VCC leads and VSS leads are connected to the power supply rails 4-2 and 5-2, concentrated near this electrically sensitive circuitry.

According to semiconductor devices of the above-described embodiments, the power supplies are provided separately for the respective circuit blocks, thus accomplishing an equivalent circuit having a single circuit block connected in series between power supplies. This will overcome the conventional problem of varying the combined resistance due to the parallel connection, suppressing a variation in supply voltage to reduce the possibility of causing malfunction. Thus, the IC chip less malfunctions and has an improved reliability.

Further, the leads which are shared by a plurality of circuit blocks and run parallel to each other, e.g., the leads 15A and 15B, each have a series of recesses and projections, the recesses and projections of the former lead being interdigitated with the projections and recesses of the latter lead. The bonding area 19 is provided on each projection. This structure can reduce the planar area for the bonding areas more than the parallel running of two leads wide over the entire length. This structure can contribute to reducing the package size.

The provision of the insulating layer 30 on the lead 15B, for example, which runs parallel to the lead 15A and is adjacent to the chip 11, as in the device shown in FIGS. 9A to 9C will prevent the wire 18A bonded to the lead 15A from contacting the lead 15B, thus achieving an improved reliability. Further, the yield can be improved as well.

By setting the top surface of the lead 15B excluding the projections lower than the top surfaces of the projections (bonding areas) 19 as in the devices shown in FIGS. 11 to 16, the wire 18A bonded to the lead 15A can be prevented from contacting the lead 15B, thus achieving an improved reliability. Further, the yield can be improved as well.

With the employment of the lead shape as in the device shown in FIGS. 17A and 17B, the bonding positions can be set nearly on a single imaginary line 32. If the bonding positions are sent on a single imaginary line 32 and the bonding positions of the leads 15A and 15B match with each other, the loop heights of the wires 18 can be made nearly the same, thus preventing unnecessary wire contact to the leads. Thus, the reliability will be improved as per the fourth and fifth embodiments. The yield can also be improved. Further, the wires 18A and 18B will have nearly the same length, the fabrication will be accomplished easily and efficiently. The uniform length of the wires 18A and 18B may be achieved by shifting the pad positions in the chip as done in the device shown in FIGS. 18A and 18B.

A plurality of circuit blocks having predetermined functions, high-potential power supply pads and low-potential power supply pads may be provided in the IC chip. The power supply pads may serve to individually supply different potentials to selected memory circuit blocks among the plurality of memory circuit blocks. One of the high-potential power supply pads may be electrically connected to the first lead member by the first connection member, and the other pad may be connected to the first lead member by the third connection member. Likewise, one of the low-potential power supply pads may be electrically connected to the second lead member by the second connection member, and the other pad may be connected to the second lead member by the fourth connection member.

This structure may allow operation supply voltages to be supplied independently to selected memory circuit blocks. Accordingly, noise originating from a change in impedance of the other memory circuit blocks will not be superimposed on the supply voltages, so that a highly-reliable IC chip that hardly malfunctions can be incorporated in the semiconductor device.

In another embodiment, at least the second connection member extends over the first lead member to electrically connect the second lead member to the second pad. An insulating member is provided at least on a portion of the first lead member which underlies the second connection member.

As the insulating member is provided at the portion where the second connection member crosses the first lead member, the second connection member will not easily be short-circuited to the first lead member. This reduces the possible short-circuiting of the inner lead portions.

According to another aspect, the position of the top surface of the second lead member excluding the projection is shifted from the position of the top surface of the first lead member, away from the first connection member.

As the distance between the second connection member and the first lead member is large, the second connection member and the first lead member will not easily contact with each other. The occurrence of the short-circuiting of the inner lead portions can therefore be reduced.

In a further embodiment, the first and second lead members each have a recess and a projection continuously, and are arranged adjacent to each other with the recess and projection of the first lead member being in engagement with the projections and recesses of the second lead member, the first connection member is electrically connected to the projection of the first lead member, and the second connection member is electrically connected to the projection of the second lead member. At least the second connection member extends over the first lead member to electrically connect the second lead member to the second pad. The connecting point between the projection of the first lead member and the first connection member and the connecting point between the projection of the second lead member and the second connection member are positioned on an imaginary straight line.

With this structure, the first and second connection members will have nearly the same length, ensuring nearly the same loop diameter. As the loop diameters become nearly equal to each other, the loops will have the same height. As a result, the distance between the second connection member and the first connection member increases, making it difficult to short-circuit the second lead member and the first lead member. The occurrence of the short-circuiting of the inner lead portions can therefore be reduced.

The present invention is not limited to the above-described embodiments.

Instead of using a mold resin to seal the chip 11, a ceramic package may be used.

In short, this invention will provide a semiconductor device whose pins will not be increased unnecessarily, which can be housed in a small package, and which incorporates a highly reliable semiconductor chip that hardly malfunctions.

## Claims

1. A semiconductor device comprising:
a semiconductor chip (11) having a plurality of sides and including at least first, second, third and fourth pads (3-1, 2-1, 3-2, 2-2) thereon, serving as outer electrodes;
a first lead member (15B) having a portion located at and extending substantially in parallel to one of said plurality of sides;
a second lead member (15A) having a portion located adjacent to said portion of said first lead member (15B);
a first connection member (18B) electrically connecting said first lead member (15B) to said first pad (3-1);
a second connection member (18A) electrically connecting said second lead member (15A) to said second pad (2-1);
a third connection member (18B) electrically connecting said first lead member (15B) to said third pad (3-2); and
a fourth connection member (18A) electrically connecting said second lead member (15A) to said fourth pad (2-2), characterized in that said first and second lead members (15A, 15B) each have a plurality of alternating wider portions and narrower portions, the wider portions constituting projection portions (19), and recesses being defined between adjacent projection portions (19), said first and third connection members (18B) being electrically connected to at least one projection portion of said first lead member (15B) and said second and fourth connection members (18A) being electrically connected to at least one projection portion of said second lead member (15A); and in that said first and second lead members (15A, 15B) are arranged adjacent to each other with said recesses and projection portions (19) of said first lead member (15B) being interdigitated with said projection portions (19) and recesses, respectively, of said second lead member (15A).

2. A semiconductor device according to claim 1, wherein said first and third connection members (18B) are electrically connected to respective projections (19) of said first lead member (15B), and said second and fourth connection members (18A) are electrically connected to respective projections (19) of said second lead member (15A).

3. A semiconductor device according to claim 1, wherein said first and third connection members (18B) are electrically connected to one projection (19) of said first lead member (15ß), and said second and fourth connection members (18A) are electrically connected to one projection (19) of said second lead member (15A).

4. A semiconductor device according to any one of claims 1 to 3, wherein at least said second connection member (18A) extends over said first lead member (15B) to electrically connect said second lead member (15A) to said second pad (2-1).

5. A semiconductor device according to claim 4, further comprising an insulating member (30) provided at least on a portion of said first lead member (15B) over which said second connection member (18A) extends.

6. A semiconductor device according to claim 4, wherein the position of the top surface of said first lead member (15B) over which said second connection member (18A) extends is offset from the plane of the top surface of said second lead member (15A), away from said second connection member (18A).

7. A semiconductor device according to claim 4, wherein the connecting points between said projections (19) of said first lead member (15B) and said first and third connection members (18B) and the connecting points between said projections (19) of said second lead member (15A) and said second and fourth connection members (18A) are positioned on an imaginary straight line (32).

8. A semiconductor device according to any one of claims 1 to 3, wherein said first, second, third and fourth pads (3-1, 2-1, 3-2, 2-2) are power supply pads.

9. A semiconductor device according to claim 8, wherein said first and third pads (3-1,3-2) are low-potential power supply pads to be supplied with a low potential (VSS) and said second and fourth pads (2-1, 2-2) are high-potential power supply pads to be supplied with a high potential (VCC).

10. A semiconductor device according to claim 9, wherein said first, second, third and fourth pads (3-1, 2-1, 3-2, 2-2) are arranged along one of said plurality of sides of said chip (11).

11. A semiconductor device according to claim 10, wherein said first, second, third and fourth pads (3-1, 2-1, 3-2, 2-2) are arranged along one of said plurality of sides of said chip (11), and said high-potential power supply pads (2-1, 2-2) and said low-potential power supply pads (3-1, 3-2) are alternately arranged.

12. A semiconductor device according to claim 10, wherein said first, second, third and fourth pads (3-1, 2-1, 3-2, 2-2) are arranged along one of said plurality of sides of said chip (11), and said high-potential power supply pads (2-1, 2-2) and said low-potential power supply pads (3-1, 3-2) are collectively arranged in separate areas.

13. A semiconductor device according to claim 10, wherein said first, second, third and fourth pads (3-1, 2-1, 3-2, 2-2) are arranged along one of said plurality of sides of said chip (11), and said high-potential power supply pads (2-1, 2-2) and said low-potential pads (3-1, 3-2) are staggered.

14. A semiconductor device according to claim 9, wherein said first, second, third and fourth pads (3-1, 2-1, 3-2, 2-2) are arranged along two of said plurality of sides of said chip (11), said high-potential power supply pads (2-1, 2-2) being arranged along one of said two sides, and said low-potential power supply pads (3-1, 3-2) being arranged along the other one of said two sides.

15. A semiconductor device according to any one of the preceding claims wherein said semiconductor chip (11) is an integrated circuit chip.

16. A semiconductor device according to claim 15, wherein said semiconductor integrated circuit chip (11) incorporates a plurality of circuit blocks (MB, CPU, RAM, ROM, LOGIC GATE) having predetermined functions.

17. A semiconductor device according to claim 16, as dependent on claim 9, wherein said first and second pads (2-1, 3-1) are electrically connected to one of said plurality of circuit blocks and said third and fourth pads (2-2, 3-2) are electrically connected to another one of said plurality of circuit blocks.

18. A semiconductor device according to claim 17, wherein said plurality of circuit blocks are memory circuit blocks (MB).

19. A semiconductor device according to claim 18, wherein said memory circuit blocks (MB) are memory circuit blocks of a dynamic type.

20. A semiconductor device according to any one of the preceding claims further comprising packing means (17) for packing at least said chip (11) to isolate said chip (11) from outside.

21. A semiconductor device according to claim 20, wherein a part of said first lead member (15B) and a part of said second lead member (15A) are led out of said packing means (17) in the same direction.

22. A semiconductor device according to claim 20, wherein a part of said first lead member (15B) and a part of said second lead member (15A) are led out of said packing means (17) in opposite directions.

23. A semiconductor device according to claim 20, 21 or 22, wherein said packing means (17) is a molding resin.

24. A semiconductor device according to any one of the preceding claims wherein said first lead member (15B) and said second lead member (15A) are positioned on a common plane.

25. A semiconductor device according to claim 24, wherein said first lead member (15B) and said second lead member (15A) are made of a single lead frame.

## Patentansprüche

1. Halbleitereinrichtung, enthaltend:
einen Halbleiterchip (11) mit mehreren Seiten und enthaltend zumindest eine erste, zweite, dritte und vierte Anschlußfläche (3-1, 2-1, 3-2, 2-2) als äußere Elektroden;
ein erstes Zuführelement (15B) mit einem Abschnitt, der bei einer der mehreren Seiten angeordnet ist und sich im wesentlichen parallel hierzu estreckt;
ein zweites Zuführelement (15A) mit einem Abschnitt, der benachbart zu dem Abschnitt des ersten Zuführelements (15B) angeordnet ist;
ein erstes Verbindungselement (18B) zum elektrischen Verbinden des ersten Zuführelements (15B) mit der ersten Anschlußfläche (3-1);
ein zweites Verbindungselement (18-A) zum elektrischen Verbinden des zweiten Zuführelements (15A) mit der zweiten Anschlußfläche (2-1);
ein drittes Verbindungselement (18B) zum elektrischen Verbinden des ersten Zuführelements (15B) mit der dritten Anschlußfläche (3-2); und
ein viertes Verbindungselement (18A) zum elektrischen Verbinden des zweiten Zuführelements (15A) mit der vierten Anschlußfläche (2-2), **dadurch gekennzeichnet, daß** das erste und zweite Zuführelement (15A, 15B) jeweils mehrere abwechselne breitere Abschnitte und engere Abschnitte aufweist, derart, daß die jeweils breiteren Abschnitte Vorsprungsabschnitte (19) bilden und daß die Vertiefungen zwischen benachbarten Vorsprungabschnitten (19) definiert sind, daß das erste und dritte Verbindungselement (18B) elektrisch mit mindestens einem Vorsprungabschnitt des ersten Zuführelements (15B) verbunden ist und daß das zweite und vierte Verbindungselement (18A) elektrsich mit mindestens einem Vorsprungabschnitt des zweiten Zuführelements (15A) verbunden ist; und daß das erste und zweite Zuführelement (15A, 15B) benachbart zueinander derart angeordnet sind, daß die Vertiefungen und Vorsprungabschnitte (19) des ersten Zuführelements (15B) jeweils in Interdigitation zu den Vorsprungabschnitten (19) und der Vertiefungen des zweiten Zuführelements (15A) vorliegen.

2. Halbleitereinrichtung nach Anspruch 1, dadurch gekennzeichnet, daß das erste und dritte Verbindungselement (18B) elektrisch mit den zugeordneten Vorsprüngen (19) des ersten Zuführelements (15B) verbunden sind und daß das zweite und vierte Verbindungselement (18A) elektrisch mit den zugeordneten Vorsprüngen (19) des zweiten Zuführelements (15A) verbunden sind.

3. Halbleitereinrichtung nach Anspruch 1, dadurch gekennzeichnet, daß das erste und dritte Verbindungselement (18A) elektrisch mit einem Vorsprung (19) des ersten Zuführelements (15B) verbunden sind und daß das zweite und vierte Verbindungselement elektrisch mit einem Vorsprung (19) des zweiten Zuführelements (15A) verbunden sind.

4. Halbleitereinrichtung nach einem der Ansprüche 1 bis 3, dadurch gekennzeichnet, daß sich zumindest das zweite Verbindungselement (18A) über das erste Zuführelement (15B) zum elektrischen Verbinden des zweiten Zuführelements (15A) an die zweite Anschlußfläche (2-1) erstreckt.

5. Halbleitereinrichtung nach Anspruch 4, dadurch gekennzeichnet, daß es ferner ein Isolationselement (30) enthält, das zumindest auf einem Abschnitt des ersten Zuführelements (15B) vorgesehen ist, über den sich das zweite Verbindungselement (18A) erstreckt.

6. Halbleitereinrichtung nach Anspruch 4, dadurch gekennzeichnet, daß die Position der oberen Oberfläche des ersten Zuführelements (15B), über die sich das zweite Verbindungselement (18A) erstreckt, gegenüber der Ebene der oberen Oberfläche des zweiten Zuführelements (15A) versetzt ist, und zwar weg von dem zweiten Verbindungselement (18A).

7. Halbleitereinrichtung nach Anspruch 4, dadurch gekennzeichnet, daß die Verbindungspunkte zwischen den Vorsprüngen (19) des ersten Zuführelements (15B) und den ersten und dritten Verbindungselementen (18B) und die Verbindungspunkte zwischen den Vorsprüngen (19) des zweiten Zuführelements (15A) und den zweiten und vierten Verbindungselementen (18A) entlang einer imaginären geraden Linie (32) positioniert sind.

8. Halbleitereinrichtung nach einem der Ansprüche 1 bis 3, dadurch gekennzeichnet, daß die erste, zweite, dritte und vierte Anschlußfläche (3-1, 2-1, 3-2, 2-2) Stromzuführanschlußflächen sind.

9. Halbleitereinrichtung nach Anspruch 8, dadurch gekennzeichnet, daß die erste und dritte Anschlußfläche (3-1, 3-2) Stromzuführanschlußflächen für niedriges Potential sind, die mit einem niedrigen Potential (VSS) versorgt werden, und daß die zweite und vierte Anschlußfläche (2-1, 2-2) Stromzuführanschlußflächen für ein hohes Potential sind, denen ein hohes Potential (VC) zugeführt wird.

10. Halbleitereinrichtung nach Anspruch 9, dadurch gekennzeichnet, daß die erste, zweite, dritte und vierte Anschlußfläche (3-1, 2-1, 3-2, 2-2) entlang einer der mehreren Seiten des Chips (11) angeordnet sind.

11. Halbleitereinrichtung nach Anspruch 10, dadurch gekennzeichnet, daß die erste, zweite, dritte und vierte Anschlußfläche (3-1, 2-1, 3-2, 2-2) entlang einer der mehreren Seiten des Chips (11) angeordnet sind, und daß die Stromzuführanschlüsse (2-1, 2-2) für hohes Potential und die Stromzuführanschlüsse (3-1, 3-2) alternierend angeordnet sind.

12. Halbleitereinrichtung nach Anspruch 10, dadurch gekennzeichnet, daß die erste, zweite, dritte und vierte Anschlußfläche (3-1, 2-1, 3-2, 2-2) entlang einer der mehreren Seiten des Chips (11) angeordnet sind, und daß die Stromzuführanschlüsse (2-1, 2-2) für hohes Potential und die Stromzuführanschlüsse (3-1, 3-2) für niedriges Potential gemeinsam in getrennten Bereichen angeordnet sind.

13. Halbleitereinrichtung nach Anspruch 10, dadurch gekennzeichnet, daß die erste, zweite, dritte und vierte Anschlußfläche (3-1, 2-1, 3-2, 2-2) entlang einer der mehreren Seiten des Chips (11) angeordnet sind, und daß die Stromzuführanschlüsse (2-1, 2-2) für hohes Potential und die Anschlußflächen für niedriges Potential (3-1, 3-2) versetzt sind.

14. Halbleitereinrichtung nach Anspruch 9, dadurch gekennzeichnet, daß die erste, zweite, dritte und vierte Anschlußfläche (3-1, 2-1, 3-2, 2-2) entlang von zwei der mehreren Seiten des Chips (11) angeordnet sind, und daß die Stromzuführanschlüsse (2-1, 2-2) für hohes Potential entlang einer der beiden Seiten angeordnet sind und daß die Stromzuführanschlüsse (3-1, 3-2) für niedriges Potential entlang der anderen der beiden Seiten angeordnet sind.

15. Halbleitereinrichtung nach einem der vorhergehenden Ansprüche, dadurch gekennzeichnet, daß der Halbleiterchip (11) ein integrierter Schaltungschip ist.

16. Halbleitereinrichtung nach Anspruch 15, dadurch gekennzeichnet, daß der integrierte Schaltungschip (11) mehrere Schaltungsblöcke (MB, CPU, RAM, ROM, LOGIC GATE) mit vorbestimmten Funktionen enthält.

17. Halbleitereinrichtung nach Anspruch 16, rückbezogen auf Anspruch 9, dadurch gekennzeichnet, daß die erste und zweite Anschlußfläche (2-1, 3-1) elektrisch mit einem der mehreren Schaltungsblöcke verbunden sind, und daß die dritte und vierte Anschlußfläche (2-2, 3-2) elektrisch mit den anderen der mehreren Schaltungsblöcken verbunden sind.

18. Halbleitereinrichtung nach Anspruch 17, dadurch gekennzeichnet, daß die mehreren Schaltungsblöcke Speicherschaltungsblöcke (MB) sind.

19. Halbleitereinrichtung nach Anspruch 18, dadurch gekennzeichnet, daß die Speicherschaltungsblöcke (MB) Speicherschaltungsblöcke vom dynamischen Typ sind.

20. Halbleitereinrichtung nach einem der vorhergehenden Ansprüche, dadurch gekennzeichnet, daß es ferner eine Gehäusevorrichtung (71) zum Aufnehmen mindestens des Chips (11) und der Isolierung des Chips (11) gegenüber der Außenseite enthält.

21. Halbleitereinrichtung nach Anspruch 20, dadurch gekennzeichnet, daß ein Teil des ersten Zuführelements (15B) und ein Teil des zweiten Zuführelements (15A) aus der Gehäusevorrichtung (17) in derselben Richtung herausgeführt sind.

22. Halbleitereinrichtung nach Anspruch 20, dadurch gekennzeichnet, daß ein Teil des ersten Zuführelements (15B) und ein Teil des zweiten Zuführelements (15A) aus der Gehäusevorrichtung (17) in entgegengesetzten Richtungen herausgeführt sind.

23. Halbleitereinrichtung nach Anspruch 20, 21 oder 22, dadurch gekennzeichnet, daß die Gehäusevorrichtung (17) aus einem Gießharz besteht.

24. Halbleitereinrichtung nach einem der vorhergehenden Ansprüche, dadurch gekennzeichnet, daß das erste Zuführelement (15B) und das zweite Zuführelement (15A) auf einer gemeinsamen Ebene positioniert sind.

25. Halbleitereinrichtung nach Anspruch 24, dadurch gekennzeichnet, daß das erste Zuführelement (15B) und das zweite Zuführelement (15A) aus einem einzigen Zuführrahmen hergestellt sind.

## Revendications

1. Un dispositif à semiconducteur comprenant :
une puce de semiconducteur (11) ayant un ensemble de côtés et portant au moins des première, seconde, troisième et quatrième plages de connexion (3-1, 2-1, 3-2, 2-2), remplissant la fonction d'électrodes extérieures;
un premier élément conducteur (15B) ayant une partie placée sur l'un des côtés de l'ensemble de côtés, et s'étendant de façon pratiquement parallèle à ce côté;
un second élément conducteur (15A) ayant une partie placée de façon adjacente à la partie précitée du premier élément conducteur (15B);
un premier élément de connexion (18B) connectant électriquement le premier élément conducteur (15B) et la première plage de connexion (3-1);
un second élément de connexion (18A) connectant électriquement le second élément conducteur (15A) à la seconde plage de connexion (2-1);
un troisième élément de connexion (18B) connectant électriquement le premier élément conducteur (15B) à la troisième plage de connexion (3-2); et
un quatrième élément de connexion (18A) connectant électriquement le second élément conducteur (15A) à la quatrième plage de connexion (2-2), caractérisé en ce que les premier et second éléments conducteurs (15A, 15B) ont chacun un ensemble de parties plus larges et de parties plus étroites alternées, les parties plus larges constituant des parties en saillie (19), et des encoches étant définies entre des parties en saillie (19) adjacentes, les premier et troisième éléments de connexion (18B) étant connectés électriquement à au moins une partie en saillie du premier élément conducteur (15B), et les second et quatrième éléments de connexion (18A) étant connectés électriquement à au moins une partie en saillie du second élément conducteur (15A); et en ce que les premier et second éléments conducteurs (15A, 15B) sont disposés de façon mutuellement adjacente, avec les encoches et les parties en saillie (19) du premier élément conducteur (15B) interdigitées avec les parties en saillie (19) et les encoches, respectivement, du second élément conducteur (15A).

2. Un dispositif à semiconducteur selon la revendication 1, dans lequel les premier et troisième éléments de connexion (18B) sont connectés électriquement à des saillies (19) respectives du premier élément conducteur (15B), et les second et quatrième éléments de connexion (18A) sont connectés électriquement à des saillies (19) respectives du second élément conducteur (15A).

3. Un dispositif à semiconducteur selon la revendication 1, dans lequel les premier et troisième éléments de connexion (18B) sont connectés électriquement à une saillie (19) du premier élément conducteur (15B), et les second et quatrième éléments de connexion (18A) sont connectés électriquement à une saillie (19) du second élément conducteur (15A).

4. Un dispositif à semiconducteur selon l'une quelconque des revendications 1 à 3, dans lequel au moins le second élément de connexion (18A) s'étend au-dessus du premier élément conducteur (15B) pour connecter électriquement le second élément conducteur (15A) à la seconde plage de connexion (2-1).

5. Un dispositif à semiconducteur selon la revendication 4, comprenant en outre un élément isolant (30) placé au moins sur une partie du premier élément conducteur (15B) au-dessus de laquelle s'étend le second élément de connexion (18A).

6. Un dispositif à semiconducteur selon la revendication 4, dans lequel la position de la surface supérieure du premier élément conducteur (15B) au-dessus de laquelle s'étend le premier élément de connexion (18A) est décalée par rapport au plan de la surface supérieure du second élément conducteur (15A), en direction opposée au second élément de connexion (18A).

7. Un dispositif à semiconducteur selon la revendication 4, dans lequel les points de connexion entre les saillies (19) du premier élément conducteur (15B) et les premier et troisième éléments de connexion (18B), et les points de connexion entre les saillies (19) du second élément conducteur (15A) et les second et quatrième éléments de connexion (18A), sont placés sur une ligne droite imaginaire (32).

8. Un dispositif à semiconducteur selon l'une quelconque des revendications 1 à 3, dans lequel les première, seconde, troisième et quatrième plages de connexion (3-1, 2-1, 3-2, 2-2) sont des plages de connexion d'alimentation.

9. Un dispositif à semiconducteur selon la revendication 8, dans lequel les première et troisième plages de connexion (3-1, 3-2) sont des plages de connexion d'alimentation de potentiel bas qui sont destinées à recevoir un potentiel bas (VSS), et les seconde et quatrième plages de connexion (2-1, 2-2) sont des plages de connexion d'alimentation de potentiel haut qui sont destinées à recevoir un potentiel haut (VCC).

10. Un dispositif à semiconducteur selon la revendication 9, dans lequel les première, seconde, troisième et quatrième plages de connexion (3-1, 2-1, 3-2, 2-2) sont disposées le long de l'un des côtés de l'ensemble de côtés de la puce (11).

11. Un dispositif à semiconducteur selon la revendication 10, dans lequel les première, seconde, troisième et quatrième plages de connexion (3-1, 2-1, 3-2, 2-2) sont disposées le long d'un côté de l'ensemble de côtés de la puce (11), et les plages de connexion d'alimentation de potentiel haut (2-1, 2-2) et les plages de connexion d'alimentation de potentiel bas (3-1, 3-2) sont disposées en alternance.

12. Un dispositif à semiconducteur selon la revendication 10, dans lequel les première, seconde, troisième et quatrième plages de connexion (3-1, 2-1, 3-2, 2-2) sont disposées le long d'un côté de l'ensemble de côtés de la puce (11), et les plages de connexion d'alimentation de potentiel haut (2-1, 2-2) et les plages de connexion d'alimentation de potentiel bas (3-1, 3-2) sont disposées collectivement dans des régions séparées.

13. Un dispositif à semiconducteur selon la revendication 10, dans lequel les première, seconde, troisième et quatrième plages de connexion (3-1, 2-1, 3-2, 2-2) sont disposées le long d'un côté de l'ensemble de côtés de la puce (11), et les plages de connexion d'alimentation de potentiel haut (2-1, 2-2) et les plages de connexion d'alimentation de potentiel bas (3-1, 3-2) sont disposées en quinconce.

14. Un dispositif à semiconducteur selon la revendication 9, dans lequel les première, seconde, troisième et quatrième plages de connexion (3-1, 2-1, 3-2, 2-2) sont disposées le long de deux des côtés de l'ensemble de côtés de la puce (11), les plages de connexion d'alimentation de potentiel haut (2-1, 2-2) étant disposées le long de l'un de ces deux côtés, et les plages de connexion d'alimentation de potentiel bas (3-1, 3-2) étant disposées le long de l'autre des deux côtés.

15. Un dispositif à semiconducteur selon l'une quelconque des revendications précédentes, dans lequel la puce de semiconducteur (11) est une puce de circuit intégré.

16. Un dispositif à semiconducteur selon la revendication 15, dans lequel la puce de circuit intégré à semiconducteur (11) comporte un ensemble de blocs de circuit (MB, CPU, RAM, ROM, LOGIC GATE) ayant des fonctions prédéterminées.

17. Un dispositif à semiconducteur selon la revendication 16, lorsqu'elle est rattachée à la revendication 9, dans lequel les première et seconde plages de connexion (2-1, 3-1) sont connectées électriquement à l'un des blocs de l'ensemble de blocs de circuits, et les troisième et quatrième plages de connexion (2-2, 3-2) sont connectées électriquement à un autre des blocs de l'ensemble de blocs de circuits.

18. Un dispositif à semiconducteur selon la revendication 17, dans lequel l'ensemble de blocs de circuits sont des blocs de circuits de mémoire (MB).

19. Un dispositif à semiconducteur selon la revendication 18, dans lequel les blocs de circuits de mémoire (MB) sont des blocs de circuits de mémoire d'un type dynamique.

20. Un dispositif à semiconducteur selon l'une quelconque des revendications précédentes, comprenant en outre des moyens de conditionnement (17) pour conditionner au moins une puce (11) de façon à isoler cette puce (11) vis-à-vis de l'extérieur.

21. Un dispositif à semiconducteur selon la revendication 20, dans lequel une partie du premier élément conducteur (15B) et une partie du second élément conducteur (15A) sortent des moyens de conditionnement (17) dans la même direction.

22. Un dispositif à semiconducteur selon la revendication 20, dans lequel une partie du premier élément conducteur (15B) et une partie du second élément conducteur (15A) sortent des moyens de conditionnement (17) dans des directions opposées.

23. Un dispositif à semiconducteur selon la revendication 20, 21 ou 22, dans lequel les moyens de conditionnement (17) consistent en une résine de moulage.

24. Un dispositif à semiconducteur selon l'une quelconque des revendications précédentes, dans lequel le premier élément conducteur (15B) et le second élément conducteur (15A) sont placés sur un plan commun.

25. Un dispositif à semiconducteur selon la revendication 24, dans lequel le premier élément conducteur (15B) et le second élément conducteur (15A) sont constitués par un seul cadre de montage.
